# EUROPÄISCHE PATENTSCHRIFT

(11) **EP 1 334 520 B1**
(45) Veröffentlichungstag und Bekanntmachung des Hinweises auf die Patenterteilung: **03.07.2013**
(21) Anmeldenummer: 01993023.9
(22) Anmeldetag: 25.10.2001
(51) Int. Cl.: H01L 23/498, H05K 3/00, H05K 3/42, H01L 21/48

(54) **FOLIENMATERIAL MIT METALLSPITZEN**
FILM MATERIAL COMPRISING METAL SPIKES
FILM CONSTITUE D'UN MATERIAU COMPRENANT DES POINTES METALLIQUES

(30) Priorität: 30.10.2000 DE 10053857; 09.11.2000 DE 10055482
(43) Veröffentlichungstag der Anmeldung: 13.08.2003
(73) Patentinhaber: GSI Helmholtzzentrum für Schwerionenforschung GmbH, 64291 Darmstadt (DE)
(72) Erfinder: ANGERT, Norbert, 64291 Darmstadt (DE); DOBREV, Dobri, 64291 Darmstadt (DE); NEUMANN, Reinhard, 64291 Darmstadt (DE); VETTER, Johann, 64291 Darmstadt (DE)
(74) Vertreter: Boeters, Hans Dietrich
(86) Internationale Anmeldenummer: PCT/EP2001/012323
(87) Internationale Veröffentlichungsnummer: WO 2002/037564

(56) Entgegenhaltungen:
- FR-A- 2 766 618
- US-A- 4 338 164
- US-A- 5 056 216
- US-A- 5 401 676
- US-A- 5 462 467
- US-A- 5 660 570
- US-A- 6 033 583
- DOBREV D ET AL: "Electrochemical preparation of metal microstructures on large areas of etched ion track membranes" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, Bd. 149, Nr. 1-2, 3. Januar 1999 (1999-01-03), Seiten 207-212, XP004157968 ISSN: 0168-583X
- "MICRO MACHINED CHIP C-4 SOCKET INTERPOSER" IBM TECHNICAL DISCLOSURE BULLETIN, IBM CORP. NEW YORK, US, Bd. 36, Nr. 6A, 1. Juni 1993 (1993-06-01), Seite 129 XP000372377 ISSN: 0018-8689

## Beschreibung

Die Erfindung betrifft ein Folienmaterial mit Metallspitzen, und verwendungen des Folienmaterials

Ein Folienmaterial und ein Verfahren zu seiner Herstellung mit gegenüberliegenden Oberflächen und konischen Durchgängen von im wesentlichen gleichmäßiger Größe einer Folie aus nichtmetallischem Material von einer Dicke zwischen 1 bis 20 µm zur Herstellung von einem Gegenstand, der als Filter verwendbar ist, um Moleküle unterschiedlicher Größen zu trennen, ist aus der Druckschrift US 3,770,532 bekannt.

Zur Herstellung der konischen Durchgänge wird eine Polycarbonatfolie mit Zerfallsprodukten des Cf-252 Atoms zur Erzeugung einer Spurendichte von etwa 1 x 10⁶ pro cm² in der Folie bestrahlt. Anschließend werden die Strahlspuren zu konischen Durchgängen geätzt.

Dieses Verfahren hat den Nachteil, daß zunächst künstliche Atome wie das Cf-252 in einem Kernreaktor erzeugt und massenspektrometrisch selektiert werden müssen, die genügend Zerfallsprodukte pro Zeiteinheit erzeugen, um eine ausreichende Spurendichte zu gewährleisten. Somit können keine natürlichen Elemente eingesetzt werden. Ferner können mit diesem Verfahren Durchgänge durch Folien, jedoch keine Folien mit Metallspitzen hergestellt werden.

Aus der Druckschrift DE 196 50 881 A1 ist ein Verfahren zur Herstellung von in z-Richtung elektrisch leitfähigen, gut kontaktierbaren und in x/y-Richtung isolierenden Folien aus Kunststoff bekannt, wobei Mikrolöcher in dem Kunststoff durch metallische Fäden ausgefüllt sind, die an ihren Enden Kappen aufweisen. Somit werden auch mit diesem Verfahren Durchgänge durch Folien geschaffen, jedoch keine Folien mit Metallspitzen hergestellt, vielmehr ist das Ziel dieses bekannten Verfahrens, gleichförmige, nahezu zylindrische metallische Fäden eingebettet in einer Kunststoff-Folie zu erreichen.

Die US 5,660,570 beschreibt eine elektrisch isolierende Schicht mit Durchgangslöchern, in denen elektrisch leitfähige Spitzen angeordnet sind.

Aufgabe der Erfindung ist es, ein Folienmaterial mit Metallspitzen zu schaffen, bei dem die Metallspitzen entweder in dem Folienmaterial eingebettet sind oder aus dem Folienmaterial herausragen.

Diese Aufgabe wird mit dem Gegenstand des Anspruchs 1 gelöst. Merkmale vorteilhafter Weiterbildungen der Erfindung ergeben sich aus den Unteransprüchen.

In einem ersten Aspekt wird ein Folienmaterial mit Metallspitzen und einander gegenüberliegenden Oberflächen geschaffen, wobei das Folienmaterial Durchgänge von einer Oberfläche zur gegenüberliegenden Oberfläche unter einem vorgegebenen Winkel in bezug auf die Oberflächen aufweist. Die Durchgänge laufen konisch zu und weisen nadelspitzenförmige konische Stifte oder Durchkontakte aus elektrisch leitendem Material auf, während das Folienmaterial aus isolierendem Kunststoff besteht. Die Spitzen weisen ein kugelförmig geformtes, die Spitzen überhöhendes Lotmaterial auf. Ein derartiges Folienmaterial hat den Vorteil, daß es in Kunststoff eingebettete nadelspitzenförmige Stifte aufweist, die unter einem Winkel in dem Folienmaterial stecken und von einer Oberfläche zur gegenüberliegenden Oberfläche reichen. Damit weist das Folienmaterial eine extreme Anisotropie sowohl für die Wärmeleitung als auch für die elektrische Leitung auf.

In einer ersten Ausführungsform der Erfindung ist die Flächendichte der konisch zulaufenden Stifte oder Durchkontakte zwischen 1 x 10⁵ Stück pro cm² und 1 x 10⁷ Stück pro cm², vorzugsweise zwischen 5 x 10⁵ Stück pro cm² und 1 x 10⁶ Stück pro cm². Diese Ausführungsform hat den Vorteil, daß eine hohe Dichte mikroskopisch feiner Stifte isoliert voneinander in der Folie eingebettet sind, ohne sich gegenseitig zu berühren.

In einer weiteren Ausführungsform der Erfindung ragen die metallischen Spitzen der Stifte oder Durchkontakte aus dem Folienmaterial einseitig heraus. Dieses hat den Vorteil, daß sich an den Spitzen eine hohe elektrische Feldstärke einstellen kann, die eine verstärkte Elektronenemission von den herausragenden Spitzen aus bewirken kann.

Bei einer weiteren bevorzugten Ausführungsform der Erfindung ist vorgesehen, daß die Dicke des Folienmaterials zwischen 10 µm und 400 µm, vorzugsweise zwischen 20 µm und 300 µm, liegt. Eine derartig dicke von metallischen Spitzen durchsetzte Folie hat den Vorteil, daß sie für viele Anwendungen anpaßbar und geeignet ist.

Die nadelförmigen konisch zulaufenden Stifte oder Durchkontakte weisen in einer weiteren Ausführungsform der Erfindung eine Steigung ihrer Mantelfläche im Bereich der Spitzen von 1:10 bis 1:30 auf. Derart schlanke Spitzen haben den Vorteil, daß sie einerseits eine hohe Feldstärke an ihren Spitzen ausbilden können und andererseits tief in andere Materialien zur Kontaktgabe eindringen können, insbesondere wenn die Spitzen aus einem härteren Metall hergestellt sind als die zu kontaktierende Fläche.

Die nadelförmigen konisch zulaufenden Stifte oder Durchkontakte weisen in einer weiteren Ausführungsform der Erfindung im Fußbereich einen Durchmesser kleiner als 10 µm, vorzugsweise zwischen 1 µm und 5 µm auf. In dieser Ausführungsform ist der Flächenbedarf für den Fußbereich derart gering, daß trotz hoher Dichte der eingebetteten metallischen Stifte in dem Folienmaterial sich die Stifte nicht in ihrem Fußbereich berühren. Dabei ist der Grundsatz berücksichtigt, daß je höher die Strahlspurdichte und damit die Dichte der Stifte ist, um so geringer muß der Durchmesser des Fußbereiches bemessen sein.

Eine bevorzugte Verwendung dieses Folienmaterials sieht vor, daß das Folienmaterial als Verbindungsmaterial in Form einer Verbindungsmatte zwischen strukturierten Leiterbahnoberflächen von zwei elektronischen Bauteilen verwendet wird. Wo diese strukturierten Leiterbahnoberflächen Leiterbahnen mit gegenüberliegenden Kontaktanschlußflächen aufweisen und/oder an Stellen, an denen sich freiliegende Leiterbahnflächen der Leiterbahnen der beiden elektronischen Bauteile kreuzen, bewirkt diese Verbindungsmatte automatisch Koppelpunkte mittels der dicht verteilten nadelspitzenförmigen konisch zulaufenden metallischen Stifte oder Durchkontakte. Eine derartige Verbindungsmatte aus dem Folienmaterial hat den Vorteil, daß die Verbindungsmatte selektiv Kontakte herstellt und selbst großflächig zwischen den zu verbindenden elektronischen Bauteilen eingelegt werden kann, ohne daß die Verbindungsmatte selektiv zu strukturieren ist.

Eine weitere Verwendung des Folienmaterials besteht darin, daß das Folienmaterial als elektrisch selektiv verbindendes Material für ein elektronisches Bauteil aus einer Mehrzahl gestapelter Halbleiterbausteine eingesetzt werden kann, wobei das Folienmaterial jeweils zwischen den Bausteinen angeordnet ist. Derartige Stapelbausteine müssen nämlich bisher mit speziell dimensionierten und strukturierten zwischenebenen ausgestattet werden, um die zu stapelnden Halbleiterbausteine selektiv miteinander zu verbinden. Der Arbeits- und Kostenaufwand für die speziell dimensionierten und strukturierten zwischenebenen kann durch das erfindungsgemäße Folienmaterial verringert werden.

In einer weiteren Verwendung des Folienmaterials ist vorgesehen, daß dieses als elektrisch verbindende Zwischenlage zwischen einem Halbleiterchip und einem Systemträger eingesetzt wird, wobei der Systemträger Leiterbahnen mit Kontaktanschlußflächen aufweist und der Chip Kontaktflächen aufweist und das Folienmaterial über seine isoliert eingelagerten Stifte elektrische Verbindungen zwischen den Kontaktflächen des Chips und den gegenüberliegenden Kontaktanschlußflächen des Systemträgers bereitstellt. Mit dieser Anwendung des Folienmaterials werden die Kosten der Verbindung zwischen Systemträger und Chip wesentlich vermindert.

Zur Kontaktherstellung deckt bei einer derartigen Verwendung des Folienmaterials dieses mindestens die gesamte Oberfläche mit Kontaktflächen auf der aktiven Seite des Halbleiterchips ab, wobei die Leiterbahnen des Systemträgers und/oder die Kontaktanschlußflächen des Systemträgers gegenüberliegend zu den Kontaktflächen des Halbleiterchips angeordnet sind. Diese Kontaktherstellung mit Hilfe der erfindungsgemäßen Folie hat den Vorteil, daß das Folienmaterial nicht exakt zugeschnitten werden muß, sondern nur in etwa der Halbleiterchipgröße entsprechen muß, wobei lediglich darauf zu achten ist, daß die Größe der Folie die Halbleiterchipgröße nicht unterschreitet.

Ein zweiter Aspekt der Erfindung sieht vor, daß das Folienmaterial auf seiner nadelfußseitigen Oberfläche eine mit den Fußenden der konisch zulaufenden Stifte oder der Durchkontakte verbundene Metallbeschichtung aufweist. Diese durchgehende Metallbeschichtung sorgt dafür, daß die Stabilität der Folie erhöht wird. Gleichzeitig sind die obigen Verwendungen mit einer derartig metallisierten Folie nicht durchführbar, da die Fußenden durch die Metallisierung kurzgeschlossen werden. Jedoch ergibt sich für diese Folienart ein weites Anwendungsfeld, da die geschlossene Metallisierung mittels Photolithographie und Ätztechnik strukturiert werden kann.

In einer Ausführungsform des zweiten Aspektes der Erfindung ist das Kunststoffmaterial im Bereich der Spitzen der konisch zulaufenden Stifte oder Durchgangskontakte herausgelöst und eine Kavität um die Spitzen herum angeordnet. Diese Ausführungsform hat den Vorteil, daß die freiliegenden Spitzen bei entsprechend hohen Feldstärken eine erhöhte Elektronenemission bereitstellen, so daß dieses Folienmaterial mit geschlossener Metallschicht auf der fußseitigen Oberfläche und freiliegenden metallischen Spitzen für Elektronenemissionsbauteile einsetzbar ist.

Eine weitere Ausführungsform der Erfindung sieht vor, daß die Kavität um die Spitzen herum oder um die Spitzen der Durchkontakte herum durch metallisches Material aufgefüllt und die Spitzen durch das metallische Material überhöht sind. Mit dieser Ausführungsform können vorteilhaft großflächige Kontakte auch auf der spitzenseitigen Oberfläche des erfindungsgemäßen Folienmaterials bereitgestellt werden. Durch geeignete Materialwahl des Materials in der Kavität und für die Überhöhung der Spitzen kann die Folie auch für feste Verbindungen mit Kontaktflächen oder Kontaktanschlußflächen eingesetzt werden.

Als metallisches Material zum Auffüllen und Überhöhen der Spitzen ist gemäß der Erfindung ein Lot vorgesehen. Mit einem derartigen Lot oder Lotball an den Spitzen können Löt- oder Bondverbindungen hergestellt werden.

In einer weiteren Ausführungsform der Erfindung weist die Metallbeschichtung auf der nadelfußseitigen Oberfläche ein Leitungsmuster auf. Dieses Leitungsmuster hat den Vorteil, daß die nadelfußseitige Oberfläche mit Schaltungen versehen werden kann, die über die nadelförmigen Spitzen mit einem Bauelement in Wirkverbindung stehen kann.

Bei einer weiteren Ausführungsform der Erfindung weist die Metallbeschichtung ein Leitungsmuster eines Systemträgers mit Kontaktanschlußflächen zur Kontaktierung von Kontaktflächen eines Halbleiterchips auf. Diese Ausführungsform der Erfindung ermöglicht eine völlig neue Strukturierung von Systemträgern für Halbleiterchips. Die Kosten für die Systemträger und insbesondere die Kosten für das Verbinden des Systemträgers mit dem Halbleiterchip können mit der erfindungsgemäßen Folie wesentlich reduziert werden.

Eine Verwendung des Folienmaterials einer Variante des zweiten Aspektes der Erfindung mit strukturierter Metallbeschichtung und mit in einer Kunststoffschicht eingebetteten nadelförmigen konisch zulaufenden Stiften oder Durchkontakten als Systemträger für ein elektronisches Bauteil mit auf dem Systemträger angeordnetem Halbleiterchip hat den Vorteil, daß auf dem Halbleiterchip in der Flip-Chip-Technologie Kontakthöcker entbehrlich werden. Somit wird die Fertigung von Halbleiterchips und Halbleiterbauteilen dieses Typs wesentlich vereinfacht und verbilligt.

Eine Verwendung des Folienmaterials mit strukturierter Halbleiterbeschichtung und mit in einer Kunststoffschicht eingebetteten nadelförmigen konisch zulaufenden Stiften oder Durchkontakten, deren Spitzen mit Lotmaterial überhöht sind, ist zur Herstellung elektronischer Bauteile mit einem auf dem Folienmaterial als Systemträger angeordneten Halbleiterchip, der mit seinen Kontaktflächen mit dem Lotmaterial verbunden ist, vorgesehen. Diese Verwendung hat den Vorteil, daß sie einen vollständigen Ersatz für die heute üblichen Systemträger bilden kann mit dem zusätzlichen Vorteil, daß ein Systemträger auf der Basis der vorliegenden Erfindung die sonst üblichen Kontakthöcker, die auf dem Chip angeordnet sind, bereits auf seinen Leiterbahnen zur Verfügung stellt.

Der Durchmesser im Fußbereich jedes Stiftes ist kleiner als 10 µm und vorzugsweise 1 bis 5 µm, und der Abrundungsradius an den Spitzen liegt zwischen 20 nm und 100 nm.

Die formgebende Kunststoff-Folie ist vorzugsweise aus Polybiphenol-A-carbonat von einer Dicke d von 10 µm bis 400 µm und die Ionen sind Schwerionen, vorzugsweise Uran-Ionen U²³⁸. Derartige Schwerionen können aufgrund ihrer elektrischen Ladung beschleunigt werden, es kann damit das Folienmaterial aus Polybiphenol-A-carbonat bestrahlt werden. Dazu werden vorzugsweise die Schwerionen auf eine kinetische Energie von 8 bis 15 MeV beschleunigt.

Weitere Merkmale, Vorteile und Ausführungsformen der Erfindung werden nun anhand der beiliegenden Figuren näher erläutert.
Fig. 1 zeigt eine erste Ausführungsform eines Folienmaterials,
Fig. 2 zeigt eine zweite Ausführungsform eines Folienmaterials,
Fig. 3 zeigt eine dritte Ausführungsform eines Folienmaterials,
Fig. 4 zeigt mit den Figuren 4a bis 4e Herstellungsschritte eines ersten Durchführungsbeispiels eines Verfahrens,
Fig. 5 zeigt mit den Figuren 5a bis 5f Herstellungsschritte eines zweiten Durchführungsbeispiels eines Verfahrens,
Fig. 5h zeigt eine erfindungsgemäße Variante des zweiten Durchführungsbeispiels des Verfahrens,
Fig. 6 zeigt mit den Figuren 6a bis 6h Herstellungsschritte eines dritten Durchführungsbeispiels eines Verfahrens,
Fig. 7 zeigt eine Vorrichtung zur Durchführung des Ätzschrittes eines Herstellungsverfahrens,
Fig. 8 zeigt ein Anwendungsbeispiel des Folienmaterials der ersten Ausführungsform,
Fig. 9 zeigt ein Anwendungsbeispiel des Folienmaterials der zweiten Ausführungsform,
Fig. 10 zeigt ein Anwendungsbeispiel einer erfindungsgemäßen Variante des Folienmaterials gemäß der zweiten Ausführungsform,

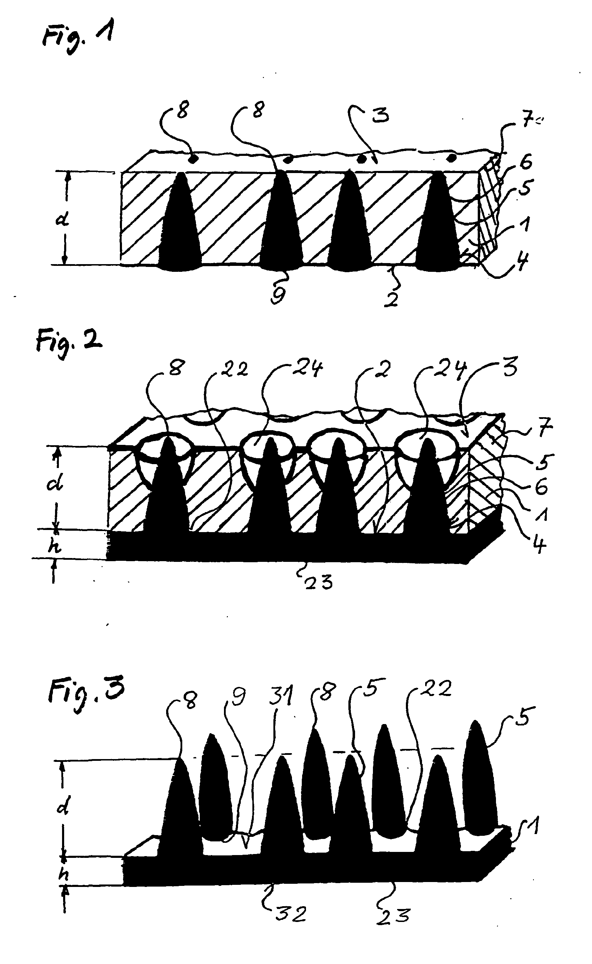

Fig. 1 zeigt eine erste Ausführungsform eines Folienmaterials. In Fig. 1 bezeichnet die Bezugsziffer 1 das Folienmaterial, die Bezugsziffer 2 eine nadelfußseitige Oberfläche, die Bezugsziffer 3 eine nadelspitzenseitige Oberfläche, die Bezugsziffer 4 einen Durchgang durch das Folienmaterial, die Bezugsziffer 5 einen nadelspitzenförmigen konischen Stift, die Bezugsziffer 6 einen Durchkontakt, die Bezugsziffer 7 ein Kunststoffmaterial und die Bezugsziffer 8 eine metallische Spitze, sowie die Bezugsziffer d die Dicke der Kunststoff-Folie 7.

Die nadelspitzenförmigen konischen Stifte 5 sind isoliert voneinander in dem Kunststoffmaterial 7 eingebettet, so daß nur ihr Fußbereich 9 in der nadelfußseitigen Oberfläche 2 und ihre metallische Spitze 8 in der nadelspitzenseitigen Oberfläche 3 frei von Kunststoffmaterial sind. Die nadelspitzenförmigen konischen Stifte 5 können somit als Durchkontakte dienen, von der nadelfußseitigen Oberfläche zur nadelspitzenseitigen Oberfläche der Folie, die eine Dicke d in dieser Ausführungsform zwischen 10 µm und 400 µm aufweist.

Der Durchmesser der Stifte im Fußbereich 9 ist kleiner als 10 µm, vorzugsweise liegt er, wie in diesem Beispiel, zwischen 1 und 5 µm. Die Flächendichte der nadelförmigen Stifte 5 hängt im wesentlichen von dem Durchmesser im Fußbereich 9 ab und darf deshalb eine vorgegebene Flächendichte nicht überschreiten. In diesem Ausführungsbeispiel der Fig. 1 liegt die Flächendichte bei 1 x 10⁶ pro cm² und kann mit kleiner werdendem Durchmesser im Fußbereich bis 1 x 10⁷ pro cm² ansteigen, ohne daß sich die nadelförmigen Stifte im Fußbereich berühren. Der Abrundungsradius der metallischen Spitzen 8 liegt in der Ausführungsform nach Fig. 1 zwischen 20 und 100 nm, während die Steigung der Mantellinie der Mantelfläche im Bereich der Spitzen zwischen 1:10 bis 1:30 liegt.

Dieses Folienmaterial der Fig. 1 kann als Verbindungsmatte zwischen strukturierten Leiterbahnoberflächen von zwei elektronischen Bauteilen verwendet werden, zumal es dort automatisch Koppelpunkte der beiden elektronischen Bauteile bildet, ohne selbst strukturiert werden zu müssen, d.h. die Folie kann insgesamt zwischen die zu koppelnden Bauteile gelegt werden, und in dem Augenblick, in dem die Bauteile und ihre Kontaktflächen aufeinander zugepreßt werden, entsteht automatisch an den jeweiligen vorgesehenen Stellen der beiden Bauteile Koppelpunkte über die in das Kunststoff-Folienmaterial eingebetteten metallischen nadelförmigen Stifte. Diese Kopplung kann überall dort realisiert werden, wo Leiterbahnen gegenüberliegende Kontaktanschlußflächen aufweisen und/oder an Stellen, an denen sich freiliegende Leiterbahnflächen der Leiterbahnen der beiden gegenüberliegenden elektronischen Bauteile kreuzen.

Beim Stapeln von Halbleiterbausteinen zu einem elektronischen Hybridbauteil kommt es darauf an, zwischen den Bausteinen Durchkontakte zu schaffen, die an vorgesehenen Stellen eine elektrische Verbindung oder einen elektrischen Kontakt zwischen den Stapelebenen schaffen. Auch hier ist das Folienmaterial aus dem Beispiel der Fig. 1 ein ideales Kopplungsmaterial, da, ohne das Folienmaterial strukturieren zu müssen, es zwischen den einzelnen Halbleiterbausteinen als Zwischenebene zu stapeln ist und somit automatisch an den Stellen, an denen gegenüberliegende Kontaktflächen der Halbleiterbausteine zu verbinden sind, diese Verbindung auch herstellt.

Eine besonders günstige und mögliche Verwendung des Folienmaterials nach Fig. 1 besteht auch darin, daß Kontaktanschlußflächen auf metallischen Systemträgern für elektronische Bauteile mit Kontaktflächen auf Halbleiterchips verbindbar werden, indem die Folie, wie sie im Prinzip in Fig. 1 gezeigt wird, zwischen dem Systemträger und dem Halbleiterchip angeordnet wird, ohne die Folie selbst zu strukturieren. Schon bei einem leichten Andruck des Halbleiterchips auf den Systemträger mit dazwischenliegendem Folienmaterial gemäß Fig. 1 entsteht überall dort eine elektrische Verbindung zwischen dem Halbleiterchip und dem Systemträger, wo einerseits auf dem Halbleiterchip Kontaktflächen vorgesehen sind und gegenüberliegend auf dem Systemträger Kontaktanschlußflächen angeordnet sind. Dazu kann das Halbleiterchip mit seiner aktiven Seite, die solche Kontaktflächen an ihrer Oberfläche trägt, analog zur Flip-Chip-Technologie auf die zwischenliegende Folie gedrückt werden.

Fig. 2 zeigt eine zweite Ausführungsform eines Folienmaterials. Gleiche Komponenten der Fig. 2, welche die gleiche Funktion wie in Fig. 1 erfüllen, werden mit gleichen Bezugsziffern bezeichnet und nicht erneut erläutert.

Gegenüber der ersten Ausführungsform nach Fig. 1 weist die zweite Ausführungsform der Fig. 2 eine die Fußbereiche auf der nadelfußseitigen Oberfläche 2 verbindende Metallbeschichtung 23 der Dicke h auf. Dieses Folienmaterial hat den Vorteil gegenüber der Fig. 1, daß diese Metallbeschichtung strukturiert werden kann, so daß Leiterbahnen mit und ohne Kontaktanschlußflächen und/oder Außenkontaktfahnen auf der Nadelfußseite herstellbar werden. Eine derart strukturierte Folie mit eingebetteten nadelförmigen Stiften kann in der Technologie moderner elektronischer Bauteile unmittelbar als Systemträger verwendet werden, wobei die Nadelspitzenseite die Kontaktflächen eines Halbleiterchips an den Stellen mit den Leiterbahnen der strukturierten Metallbeschichtung 23 verbinden, wo auf dem Halbleiterchip Kontaktflächen angeordnet sind.

Außer der zusätzlichen strukturierbaren Metallbeschichtung 23 zeigt Fig. 2 Kavitäten 24 rund um jede metallische Spitze 8, so daß die metallische Spitze 8 völlig frei von Kunststoff ist. Dieses Freisetzen der metallischen Spitzen 8 hat den Vorteil, daß für Elektronenemissionsbauteile eine intensive Elektronenemission an den Spitzen 8 des Folienmaterials möglich wird, wenn eine entsprechende Feldstärke an den Spitzen 8 konzentriert auftritt, wobei diese Elektronenemission ihrerseits wiederum entsprechende Materialien gegenüber der nadelspitzenseitigen Oberfläche zum Fluoreszenzleuchten anregen kann. Dabei kann die strukturierbare metallische Beschichtung 23 als eine der Elektroden zur Erzeugung der notwendigen Feldstärke verwendet werden.

Durch Strukturieren der Metallbeschichtung 23 lassen sich somit flache Leuchtbildschirme herstellen. Für eine derartige Ausführungsform kann die Metallbeschichtung 23 äußerst dünn ausgeführt werden, so daß die Metallbeschichtung durchscheinend wird. Ferner kann sie mit einem elektrisch leitenden Oxid wie Indiumoxid beschichtet werden, das wie eine Glasplatte durchsichtig und elektrisch leitend ist. Somit lassen sich mit Hilfe des Folienmaterials hochpräzise flache Bildschirme herstellen.

Die Geometrie der in das Kunststoffmaterial eingebetteten nadelförmigen Stifte und die Flächendichte dieser Stifte liegt in dem gleichen Bereich wie bei der ersten Ausführungsform nach Fig. 1. Auch die Dicke des Folienmaterials d liegt in den gleichen Bereichen zwischen 10 und 400 µm, je nach Anwendungsfall. Die Dicke der Metallbeschichtung kann je nach Anwendungsfall zwischen wenigen Nanometern und mehreren Mikrometern liegen. Wenn die Metallbeschichtung nur wenige Nanometer beträgt, wird sie üblicherweise auf eine Dicke h von mehreren Mikrometern durch elektrisch leitende Gläser wie Indiumoxid verstärkt. In diesem Fall ist dann die Beschichtung 23 eine Verbundglasbeschichtung mit elektrisch leitenden Eigenschaften.

In einer erfindungsgemäßen Variante der zweiten Ausführungsform nach Fig. 2 können die Kavitäten mit einem weiteren Material wie einem Lötmaterial aufgefüllt sein, so daß nicht nur Andruckkontakte realisierbar sind, sondern metallische Verbindungen mit beispielsweise Kontaktflächen von Halbleiterchips möglich werden. Um die Kavitäten an den metallischen Spitzen 8 mit Lot aufzufüllen, kann ein einfaches Tauchverfahren in einem Lötbad vorgenommen werden, oder das Folienmaterial über ein Lötschwallbad mit seiner folienspitzenseitigen Oberfläche geführt werden.

Aufgrund der Benetzungseigenschaften des Lotes zu den metallischen Spitzen 8 wird sich an jeder Spitze 8 eine Lötkugel von wenigen Nanometern Durchmesser ausbilden, während das nicht benetzende Kunststoffmaterial frei von Lot bleibt. Eine derartige Variante der zweiten Ausführungsform der Erfindung hat weiterhin den Vorteil, daß in der Flip-Chip-Technologie die Chips selbst an ihren Kontaktflächen nicht mehr mit Kontakthöckern versehen werden müssen, da diese Funktion nun von den Lötkugel auf den Metallspitzen 8 übernommen werden kann.

Zusätzlich kann die Metallbeschichtung 23 für diesen Anwendungsfall zu Kontaktanschlußflächen sowie Außenkontaktfahnen strukturiert werden und einen kompletten Systemträger bilden. Ein derartiger Systemträger hat die Aufgabe, die mikroskopisch kleinen Kontaktflächen des Halbleiterchips auf mechanisch anschließbare und kontaktierbare Außenkontaktfahnen zu vergrößern. Außerdem erfüllen derartige Systemträger die Aufgabe, eventuell eine zusätzliche Verdrahtungsebene zur Verfügung zu stellen, um mehrere Halbleiterchips auf dem Systemträger miteinander zu verschalten.

Die in Fig. 2 gezeigten Kavitäten 24 im Bereich der metallischen Spitzen 8 können durch Anlösen des Kunststoffs mittels Methanbichlorid erfolgen.

Fig. 3 zeigt eine dritte Ausführungsform des Folienmaterials. Komponenten der dritten Ausführungsform in Fig. 3, welche die gleichen Funktionen wie in Fig. 1 oder in Fig. 2 erfüllen, werden mit gleichen Bezugszeichen bezeichnet und nicht erneut erläutert. Der wesentliche Unterschied zwischen den Ausführungsformen nach Fig. 1 und Fig. 2 ist bei Fig. 3, daß nun die Kunststoff-Folie völlig aufgelöst wurde, so daß eine reine Metallfolie der Dicke h vorliegt mit nadelförmigen Stiften auf einer der Oberflächen, die eine Höhe aufweisen, welche der Dicke d der abgelösten oder aufgelösten Kunststoff-Folie entspricht.

Mit einem derartigen Folienmaterial aus Metall mit Metallspitzen und einander gegenüberliegenden Oberflächen, wobei die Metallfolie auf mindestens einer Oberfläche nadelförmige Stifte aufweist, die unter einem vorgegebenen Winkel von der Folienoberfläche aufragen, und im Fußbereich der Stifte einen Durchmesser kleiner 10 µm, vorzugsweise 1 bis 5 µm, aufweisen, kann in vorteilhafter Weise als flächiges Elektronenemissionsmaterial eingesetzt werden, da beim Anlegen eines Potentials an die Metallfolie sich eine hohe Feldstärke an den metallischen Spitzen 8, die einen Abrundungsradius von wenigen Nanometern aufweisen, ausbildet, so daß die Austrittsarbeit für Elektronen an diesen Stellen hoher Feldstärke überwunden wird. Aufgrund der hohen Dichte von 1 x 10⁵ Stiften pro cm² bis 1 x 10⁷ Stiften pro cm², vorzugsweise 5 x 10⁵ Stiften pro cm² bis 1 x 10⁶ Stiften pro cm² bildet sich eine makroskopisch großflächig erscheinende Elektronenemissionswolke über einem derartigen Folienmaterial aus, die für die verschiedensten Anwendungsgebiete eingesetzt werden kann.

Andere Anwendungsgebiete dieser metallischen Folie sind flächige Andruckkontakte, bei denen diese Folie zwischengelegt wird, und aufgrund der dichten und feinen nadelförmigen Stifte können Unebenheiten und Rauhigkeiten zwischen zwei zu kontaktierenden metallischen Flächen ausgeglichen werden, da die Stifte in dem Bereich äußerst elastisch sind und Rauhigkeiten und Unebenheiten bei gleichzeitig guter Kontaktgabe ausgleichen.

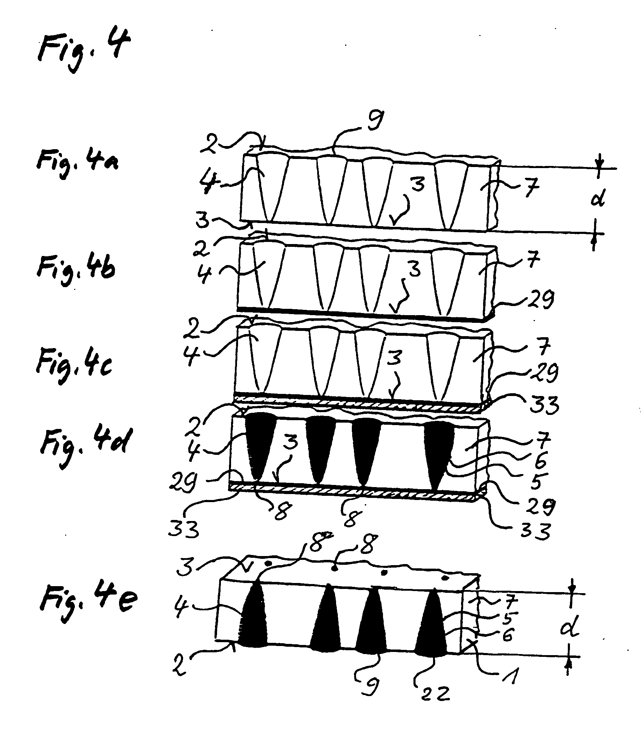

Fig. 4 zeigt mit den Figuren 4a bis 4e Herstellungsschritte eines ersten Durchführungsbeispiels eines Verfahrens. Bei diesem Durchführungsbeispiel des Verfahrens entsteht ein Folienmaterial, wie es die erste Ausführungsform nach Fig. 1 zeigt. Zunächst wird von einer Folie aus Kunststoffmaterial 7 ausgegangen, das in dieser Ausführungsform aus einem Polybiphenol-A-Carbonat einer Dicke von 10 bis 400 µm besteht.

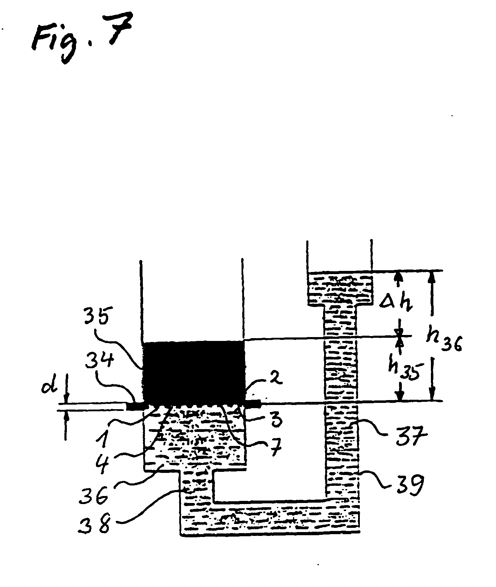

Dieses Folienmaterial wird mit Ionen bombardiert, so daß eine Flächendichte der Ionenstrahlspuren in der Folie von 1 x 10⁵ Spuren pro cm² bis 1 x 10⁷ Spuren pro cm2 entstehen, vorzugsweise zwischen 5 x 10⁵ Spuren pro cm² bis 1 x 10⁶ Spuren pro cm². In dem Ausführungsbeispiel der Fig. 4 werden Schwerionen, wie Uran-Ionen U²³⁸ beschleunigt und die Folie mit diesen Ionen bombardiert. Die Ionenspuren werden dann in einer Ätzvorrichtung, wie sie Fig. 7 zeigt, einseitig von der nadelfußseitigen Oberfläche 2 aus geätzt.

Dabei entstehen trichterförmige oder nadelförmige Durchgänge 4, wie sie in Fig. 4a gezeigt werden, wenn von der gegenüberliegenden Seite, nämlich der nadelspitzenseitigen Fläche der Oberfläche 3, eine Ätzstoplösung angeboten wird, die mit einem Differenzdruck gegenüber dem Druck auf der nadelfußseitigen Oberfläche beaufschlagt wird, so daß sie sobald ein Durchätzen erfolgt ist, in die nadelspitzenseitige Öffnung der Durchgangsöffnung einströmt und den Ätzvorgang beendet. Eine derartige Ätzstoplösung ist beispielsweise eine 6-molare Natronlaugelösung, die mit 10 Vol-% Methanol gemischt ist.

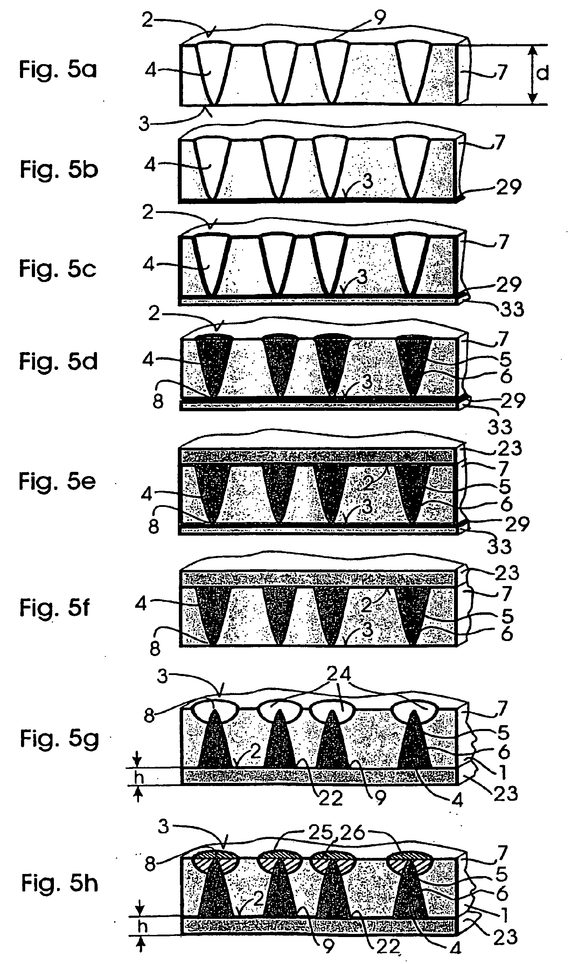

Das Methanol sorgt vorteilhaft für eine Auflösung anhaftender organischer Verbindungen auf der Oberfläche des Folienmaterials, während die Natronlaugelösung selbst den Ätzstop gegenüber der Ätzlösung herbeiführt. Zum Durchätzen der Folie einer Dicke d von 10 bis 400 µm ist eine Zeit von 2 bis 16 Stunden erforderlich, wobei die Ätzlösung bei einer Temperatur zwischen 310 und 320 K gehalten wird. Bevorzugt wird für den Ätzvorgang eine Zeit von 6 bis 10 Stunden. Wenn auch das Folienmaterial, wie es Fig. 4a zeigt, eine nadelspitzenförmige Auflösung des Kunststoffmaterials 7 im Bereich der Ionenspuren zeigt, ist die Ionenspur selbst zylinderförmig und erstreckt sich durch das gesamte Material. Diese zylinderförmige Ionenspur wird für die zweite Ausführungsform, wie sie in Fig. 2 und ihr Herstellungsverfahren in Fig. 5 gezeigt wird, ausgenutzt.

Nach dem einseitigen Ätzen der nadelspitzenförmigen Durchgänge 4 in das Folienmaterial wird im nächsten Schritt, der mit Fig. 4b gezeigt wird, eine geschlossene dünne Metallschicht von wenigen Nanometern auf die nadelspitzenseitige Oberfläche 3 gesputtert. Diese gesputterte Schicht 29 verbindet die nadelspitzenseitigen Öffnungen der Durchgänge 4 und kann, wie Fig. 4c zeigt, durch eine zusätzlich galvanisch abgeschiedene Metallschicht 33 verstärkt werden. Diese galvanisch abgeschiedene Metallschicht 33 wird dann als Elektrode verwendet, um, wie es Fig. 4d zeigt, die nadelspitzenförmigen Durchgänge 4 mit einem Metall zu nadelförmigen Stiften 5 zu füllen. Für das Sputtern der dünnen Metallbeschichtung 29 wird vorzugsweise Gold eingesetzt, während bei der galvanischen Abscheidung der Metallbeschichtung 33 eine Kupferlegierung abgeschieden wird.

In dem Herstellungsschritt der Fig. 4d wird der nadelförmige konische Durchgang 4 durch eine galvanische Abscheidung mit einer Kupferlegierung oder mit einem Kupfer gefüllt. Abschließend kann zur Herstellung einer Ausführungsform, wie sie in Fig. 1 gezeigt wird, die galvanische Beschichtung 33 und auch die gesputterte Beschichtung 29 von der nadelspitzenseitigen Oberfläche 3 abgeätzt werden, so daß die nadelförmigen Stifte, wie es die Fig. 4e zeigt, nun isoliert voneinander in dem Folienmaterial aus Kunststoff liegen. Die vielseitige Verwendung einer derartigen von metallischen nadelförmigen Stiften durchsetzten Folie wurde bereits ausführlich erörtert und wird deshalb hier weggelassen.

Fig. 5 zeigt mit den Figuren 5a bis 5f Herstellungsschritte eines zweiten Durchführungsbeispiels Verfahrens zur Herstellung der zweiten Ausführungsform des Folienmaterials. Auch bei diesem Herstellungsverfahren wird, wie in Fig. 4, von einem Folienmaterial aus Biphenol-A-Carbonat ausgegangen, das mit Schwerionen bestrahlt wird. Die Ionenspuren werden, wie es Fig. 5a zeigt, zu nadelspitzenförmigen Durchgängen 4 in dem Folienmaterial geätzt, wobei eine gleichförmige Dichte, wie bereits in Fig. 4a erläutert, eingehalten wird. Danach wird analog zu Fig. 4b in Fig. 5b eine dünne Metallschicht 29 auf der nadelspitzenseitigen Oberfläche 3 durch Sputtern abgeschieden und anschließend im Schritt der Fig. 5c diese Schicht durch beispielsweise galvanische Abscheidung zu einer Metallbeschichtung 33 verstärkt.

Ausgehend von dieser Beschichtung werden nun in Fig. 5d die Durchgänge mit Metall aufgefüllt, das kann eine Kupferlegierung sein, die galvanisch in den Durchgängen abgeschieden wird, indem die Metallbeschichtung 33 auf Kathodenpotential gelegt wird. Mit einem zusätzlichen Verfahrensschritt, der in Fig. 5e gezeigt wird, wird nun die fußseitige Oberfläche 2 der Folie mit einer galvanisch abgeschiedenen Beschichtung 23 verstärkt. Diese Beschichtung 23 kann jedoch auch eine kombinierte Beschichtung aus einer dünnen abgeschiedenen Metallschicht und einem elektrisch leitenden Oxid wie Indiumoxid sein, falls eine durchscheinende oder durchsichtige Anwendung erwünscht ist.

Bereits nach dem Verfahrensschritt, der in Fig. 5f gezeigt wird, steht eine Folie zur Verfügung, die einerseits nadelförmige Kontaktspitzen auf der Nadelspitzenseite der Folie aufweist und eine metallische Oberfläche auf der nadelfußseitigen Oberfläche besitzt. Diese metallische Oberfläche kann in einem weiteren Schritt, der nicht gezeigt ist, strukturiert werden, so daß eine Folie mit einer elektrischen Schaltung entsteht, wobei Leiterbahnen, Außenkontaktfahnen und Kontaktanschlußflächen mit dieser Struktur realisiert werden können.

Um die Wirkung der Metallspitzen 8 zu verstärken oder eine bessere Kontaktfähigkeit zu erreichen, kann in einem weiteren Schritt, der in Fig. 5g gezeigt wird, das Folienmaterial rund um die metallischen Spitzen zu Kavitäten 24 ausgewaschen, aufgelöst oder ausgeätzt werden, wobei bei diesem Schritt die Tatsache genutzt wird, daß die Ionenspuren zylindrische Spuren im Folienmaterial hinterlassen, so daß nun die im Schritt 4a bzw 4a eingesetzte Ätzlösung nur begrenzt den Kunststoff, nämlich im Bereich der zylindrischen Ionenspuren, angreift. Somit entstehen gezielt Kavitäten, die sich rund um die metallischen Spitzen 8, wie es Fig. 5g zeigt, bilden.

In einer Variation des Verfahrens kann anschließend eine Beispiel eines erfindungsgemäßen Folienmaterials hergestellt werden, wobei ein Prozeß zur Kontaktspitzenerhöhung und zur Kontaktverbreiterung an den Kontaktspitzen 8 erfolgen kann. Wie Fig. 5h zeigt, wird dazu ein weiteres Metallmaterial im Bereich der Kavitäten 24 abgeschieden. Dies kann in besonders vorteilhafter Weise durch das Abscheiden von Lötmaterial geschehen, wobei die nadelspitzenseitige Oberfläche mit Kavitäten 24 über ein Lötschwallbad geführt wird und dabei die Benetzungsfähigkeit oder der Benetzungsunterschied zwischen Kunststoffmaterial und metallischer Spitze ausgenutzt wird. Während das Lötmaterial sich kugelförmig um die Metallspitze gruppiert und damit eine Metallspitzenerhöhung und Verbreiterung bewirkt, wird das umgebende Kunststoffmaterial nicht benetzt, und somit bleibt es frei von Lötmaterial. Ein derartiges Material, wie es die Fig. 5h zeigt, ist vielseitig einsetzbar, zumal auch hier die Beschichtung 23, die entweder eine reine Metallbeschichtung oder eine Kombibeschichtung aus Metall und leitenden Oxiden sein kann, strukturiert werden kann. Die Höhe h dieser Beschichtung liegt zwischen 10 und 50 µm.

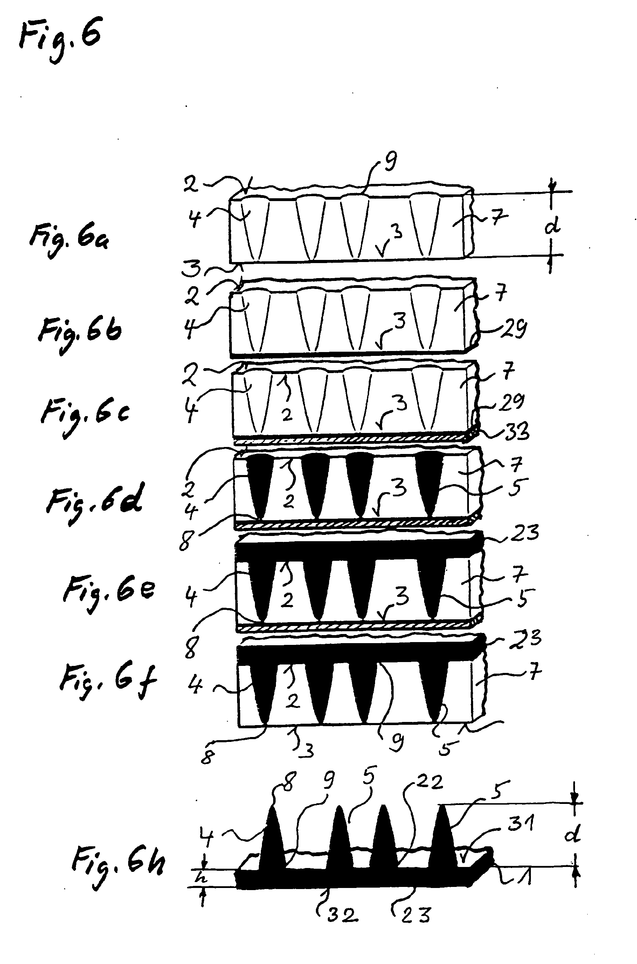

Fig. 6 zeigt mit den Figuren 6a bis 6h Herstellungsschritte eines dritten Durchführungsbeispiels des Verfahrens zur Herstellung der dritten Ausführungsform des Folienmaterials. Auch bei diesem Ausführungsbeispiel wird von einer Kunststoff-Folie 7 ausgegangen, die entsprechend mit Ionenstrahlen bestrahlt wird, wie es bereits für die Figuren 4 und 5 gezeigt wurde. Das Folienmaterial hat dabei eine Dicke d von 10 bis 400 µm. Nach dem Ätzen der Durchgänge 4, wie es Fig. 6a zeigt, wird mit einem weiteren Schritt, der in Fig. 6b gezeigt wird, eine dünne Metallschicht 29 auf der nadelspitzenseitigen Oberfläche 3 der Durchgänge 4 abgeschieden. Diese dünne abgeschiedene Metallschicht, die entweder aufgedampft oder aufgesputtert sein kann, kann anschließend durch eine galvanisch abgeschiedene Schicht 33, wie sie Fig. 6c zeigt, verstärkt werden.

Von der Spitzenseite aus werden dann die Durchgänge 4 mit Metall gefüllt, so daß nadelförmige Stifte 5 entstehen, wie sie Fig. 6d zeigt. Schließlich wird im folgenden Schritt, der in Fig. 6e gezeigt wird, eine die Fußbereiche der nadelförmigen Stifte verbindende Metallschicht oder eine Kombischicht aus Metall und leitenden Oxiden abgeschieden. Diese Schicht ist mit dem Bezugszeichen 23 bezeichnet. Anschließend kann, wie es Fig. 6f zeigt, die Beschichtung auf der nadelspitzenseitigen Oberfläche 3 vollständig abgeätzt werden, und anschließend wird, wie es Fig. 6a zeigt, das gesamte Kunststoffmaterial 7, das in Fig. 6f noch vorhanden ist, mit beispielsweise Methandichlorid aufgelöst.

Als Ergebnis dieses Verfahrens nach Fig. 6 ergibt sich die dritte Ausführungsform, die in einem Folienmaterial aus Metall mit Metallspitzen und einander gegenüberliegenden Oberflächen besteht, wobei das Folienmaterial aus Metall selbst eine Dicke h von 10 bis 50 µm aufweist, während die Länge der nadelförmigen metallischen Stifte zwischen 10 und 400 µm, je nach Dicke d der Kunststoff-Folie 7, ist. Die Flächendichte der Stifte auf der Metallfolie entspricht der Flächendichte der Durchgänge 4 bzw. der Flächendichte der Ionenstrahlspuren in dem Kunststoffmaterial 7. Die Größenordnung dieser Dichte wurde schon mehrfach oben beschrieben.

Ein derartiges Folienmaterial, wie es im Prinzip die Fig. 6h zeigt, kann als Andruckkontaktmaterial zwischen zwei Kontaktflächen verwendet werden, da es sich aufgrund der elastischen Spitzen den Rauhigkeiten und Unebenheiten der gegenüberliegenden Kontaktflächen anpaßt. Derartige Flächenkontakte können mikroskopisch klein, aber auch großflächig ausgeführt werden.

Fig. 7 zeigt eine Vorrichtung zur Durchführung des Ätzschrittes der Durchführungsbeispiele des Herstellungsverfahrens. Dazu wird die bestrahlte Kunststoff-Folie mit einer Flächendichte von Ionenstrahlspuren von 1 x 10⁵ Spuren pro cm² bis 1 x 10⁷ Spuren pro cm² als Trennwand 34 zwischen zwei Flüssigkeitssäulen 35 und 36 eingespannt. Die Flüssigkeitssäule 35 besteht aus einer Ätzlösung, die in diesem Ausführungsbeispiel eine 6-molare Natronlaugelösung mit 10 Vol-% Methanol ist.

Der Volumenanteil an Methanol kann durchaus variieren. Er muß und soll aber ausreichend sein, um organische Kontaminationen von dem Folienmaterial zu lösen und fernzuhalten, damit die Natronlaugelösung relativ gleichmäßig das Kunststoffmaterial im Bereich der Ionenstrahlspuren auflösen kann.

Die zweite Flüssigkeitssäule 36, die auf der gegenüberliegenden Oberfläche des Kunststoff-Folienmaterials angeordnet ist, besteht in diesem Ausführungsbeispiel der Fig. 7 aus einer 5%-igen Schwefelsäure, wobei die Höhendifferenz Δh der beiden Flüssigkeitssäulen 35 und 36 einen hydrostatischen Druck ergibt, der in dem Augenblick, in dem das Folienmaterial der Trennwand 34 im Bereich der Ionenspuren durchgeätzt ist, dafür sorgt, daß die Ätzstoplösung über die entstandenen Durchgangsöffnungen in der nadelspitzenseitigen Oberfläche fließt und somit den Ätzfortschritt im Spitzenbereich der Durchgänge durch das Folienmaterial stoppt.

Die beiden Flüssigkeitssäulen 35 und 36 sind in einem U-förmigen Gefäß untergebracht, wobei der eine Schenkel 38 des U-förmigen Gefäßes 37 die Trennwand 34 aufnimmt, über der die Flüssigkeitssäule 35 mit der Ätzlösung steht, und im unteren Bereich des Schenkels 38 die Ätzstoplösung anbietet, die aufgrund des überhöhten Niveaus der Ätzstoplösung im zweiten Schenkel 39 eine Druckdifferenz auf die Unterseite der Trennwand 34, die von dem zu ätzenden Folienmaterial gebildet wird, ausübt.

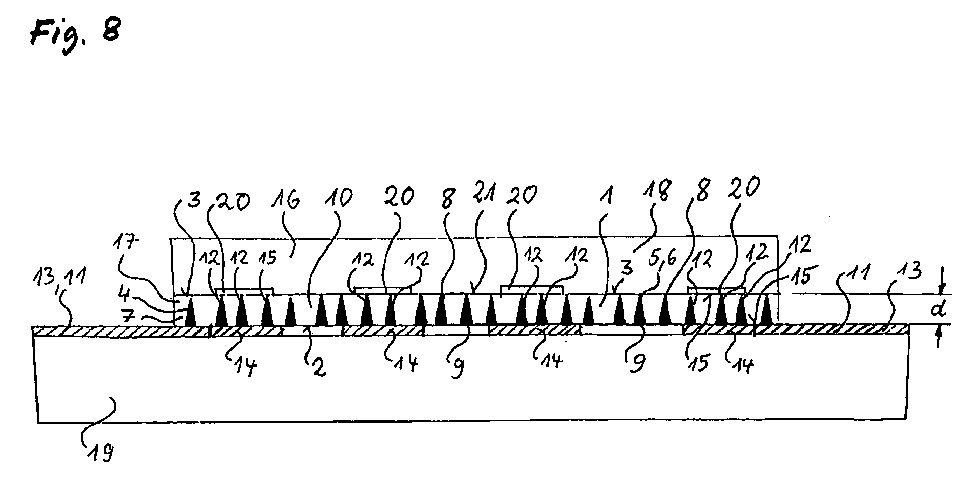

Fig. 8 zeigt ein Anwendungsbeispiel des Folienmaterials der ersten Ausführungsform. In Fig. 8 werden Komponenten, die gleiche Funktionen wie in Fig. 1 erfüllen, mit gleichen Bezugszeichen versehen. Eine Erläuterung dieser Bezugszeichen entfällt folglich. Darüber hinaus zeigt Fig. 8 mit dem Bezugszeichen 19 einen Substratträger, der eine strukturierte Metallbeschichtung mit Leiterbahnen 13 und Kontaktanschlußflächen 14 aufweist. Mit der Bezugsziffer 18 wird ein Halbleiterchip gezeigt, während die Bezugsziffer 21 die Oberfläche des Halbleiterchips und die Bezugsziffer 20 Kontaktflächen des Halbleiterchips 18 zeigt.

Zwischen dem Halbleiterchip 18 und dem Systemträger 19 ist ein Folienmaterial 1 der ersten Ausführungsform angeordnet, wobei der Fußbereich der nadelförmigen Stifte 5 die Kontaktanschlußflächen 14 des Systemträgers 19 kontaktiert und die Spitzen 8 der nadelförmigen Stifte 5 die Kontaktflächen 20 des Halbleiterchips 18 auf der aktiven Oberfläche 21 des Halbleiterchips berühren. Um eine Verbindung zwischen den Kontaktflächen 20 des Halbleiterchips 18 und den Kontaktanschlußflächen 14 des Systemträgers 19 herzustellen, muß das Folienmaterial 1 in keiner Weise strukturiert sein, sondern lediglich mindestens die Flächengröße des Halbleiterchips 18 aufweisen und kann ohne besondere Justage zwischen dem Halbleiterchip 18 und dem Systemträger 19 angeordnet werden. Ein leichter Kontaktdruck des Halbleiterchips 18 in Richtung auf den Systemträger 19 genügt, um bereits einen ausreichenden Kontakt zwischen Halbleiterchip 18 und Systemträger 19 herzustellen. Eine derartige Ausführungsform ist besonders günstig für Massenartikel wie Halbleiterchips für Chipkarten oder ähnliche Anwendungen einsetzbar.

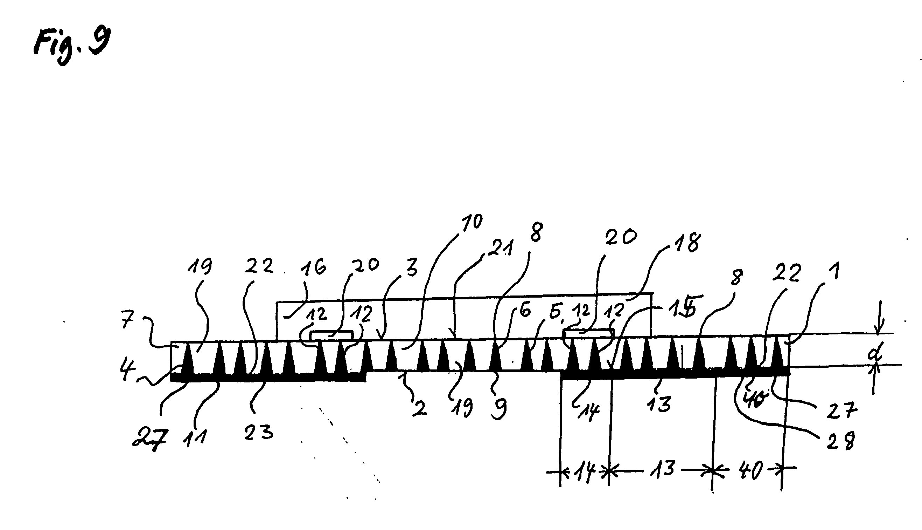

Fig. 9 zeigt ein Anwendungsbeispiel des Folienmaterials der zweiten Ausführungsform. Das Folienmaterial der zweiten Ausführungsform weist auf der fußseitigen Oberfläche der nadelförmigen Stifte 5 eine Metallschicht auf. Diese Metallschicht ist in dem Anwendungsbeispiel nach Fig. 9 zu Leiterbahnen 13, Außenkontaktfahnen 40 und Kontaktflächen 14 strukturiert. Die Außenkontaktfahnen 40 liegen außen und können von außen kontaktiert werden. Die Leiterbahnen führen von den Kontaktanschlußfahnen 40 zu den Kontaktanschlußflächen 14 und über die nadelförmigen Stifte 5 zu den Kontaktflächen 20 des Halbleiterchips 18. Somit ersetzt das Folienmaterial der zweiten Ausführungsform vollständig den sonst üblichen Systemträger und trägt dazu bei, die Dicke eines elektronischen Bauteils, wie es Fig. 8 zeigt, wesentlich zu vermindern.

Außerdem liegen die Außenkontaktfahnen 40 völlig frei, so daß das elektronische Bauteil nach Fig. 9 in eine Chipkarte eingebettet werden kann und die Außenkontaktfahnen 40 für die Kontaktgabe mit einem Automaten zugänglich werden. Auch in dieser Ausführungsform reicht ein leichter Andruck des Systemträgers auf das Chip, um einen ausreichenden Kontakt zwischen Kontaktflächen 20 des Chips und Kontaktanschlußflächen 14 des Systemträgers 19 herzustellen.

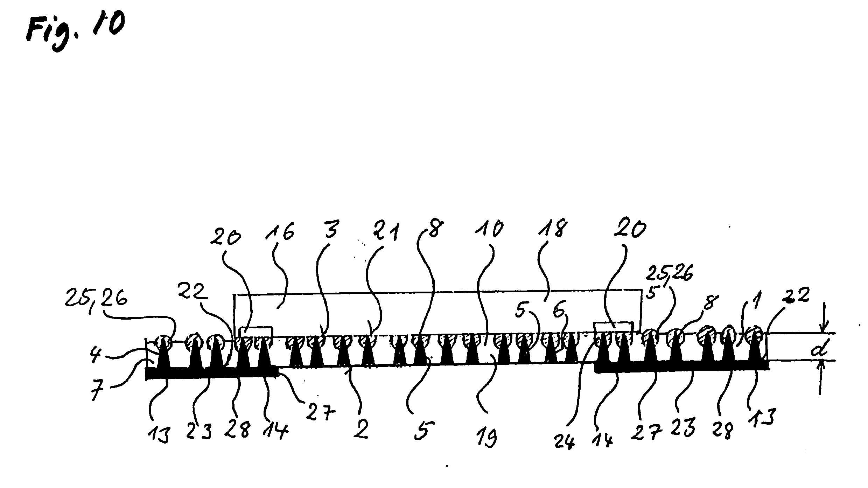

Fig. 10 zeigt ein Anwendungsbeispiel der erfindungsgemäßen Variante des Folienmaterials. Komponenten mit gleicher Funktion wie in den Figuren 1, 2, 8 und 9 werden mit gleichen Bezugszeichen bezeichnet und nicht erneut erläutert. Darüber hinaus zeigt Fig. 10 mit dem Bezugszeichen 25 ein metallisches Material 25 in den Kavitäten 24 der zweiten Ausführungsform. In diesem Ausführungsbeispiel der Fig. 10 besteht das metallische Material 25 in den Kavitäten 24 aus einem Lot. Dieses Lot bildet um die Spitzen 8 der nadelförmigen Stifte 5 einen Lotball 26 aus Lötmaterial, der beim Verbinden von Kontaktflächen 20 eines Halbleiterchips 18 mit dem Systemträger 19 eine Lötverbindung eingeht. Damit wird eine von einem Andruck unabhängige elektrische Verbindung zwischen den Kontaktflächen 20 des Halbleiterchips 18 und Kontaktanschlußflächen 14 des Systemträgers 19 geschaffen.

**Bezugszeichenliste**

| | |
|---|---|
| 1 | Folienmaterial |
| 2 und 3 | gegenüberliegende Oberflächen |
| 2 | nadelfußseitige Oberfläche |
| 3 | nadelspitzenseitige Oberfläche |
| 4 | Durchgänge |
| 5 | nadelförmige Stifte |
| 6 | Durchkontakte |
| 7 | Kunststoff |
| 8 | metallische Spitzen |
| 9 | Fußbereich |
| 10 | Verbindungsmaterial |
| 11 | strukturierte Leiterbahnflächen |
| 12 | Koppelpunkte |
| 14 | Kontaktanschlußflächen |
| 15 | Leiterbahnoberflächen |
| 16 | elektronisches Bauteil |
| 17 | Zwischenlage |
| 18 | Halbleiterchip |
| 19 | Systemträger |
| 20 | Kontaktfläche |
| 21 | Oberfläche des Halbleiterchips |
| 23 | Beschichtung aus Metall oder elektrisch leitendem Oxid |
| 24 | Kavität |
| 25 | metallisches Material in der Kavität |
| 26 | Lötmaterial |
| 27 | Leitungsmuster |
| 28 | strukturierte Metallbeschichtung |
| 29 | Metallschicht auf der nadelspitzenseitigen Oberfläche |
| 30 | Metallfolie |
| 31 und 32 | gegenüberliegende Oberflächen der Metallfolie |
| 33 | galvanisch verstärkte Metallschicht |
| 34 | Trennwand |
| 35 und 36 | Flüssigkeitssäulen |
| 37 | U-förmiges Gefäß |
| 38 | erster Schenkel |
| 39 | zweiter Schenkel |
| 40 | Außenkontaktflächen |

## Patentansprüche

1. Folienmaterial mit Metallspitzen (8) und einander gegenüberliegenden Oberflächen (2 und 3), wobei das Folienmaterial Durchgänge (4) von einer Oberfläche (2) zur gegenüberliegenden Oberfläche (3) unter einem vorgegebenen Winkel in bezug auf die Oberflächen (2 und 3) aufweist, die konisch zulaufen, und die Durchgänge (4) Stifte (5) oder Durchkontakte (6) aufweisen, wobei die Stifte oder Durchkontakte nadelspitzförmig konisch geformt sind und elektrisch leitendes Material aufweisen während das Folienmaterial (1) aus isolierendem Kunststoff besteht, **dadurch gekennzeichnet, daß** die Spitzen ein kugelförmig geformtes, die Spitzen überhöhendes, Lotmaterial aufweisen.

2. Folienmaterial nach Anspruch 1, **dadurch gekennzeichnet, daß** die Flächendichte der konisch zulaufenden Stifte (5) oder Durchkontakte (6) zwischen 1 x 10⁵ Stück pro cm² und 1 x 10⁷ Stück pro cm², vorzugsweise zwischen 5 x 10⁵ Stück pro cm² und 1 x 10⁶ Stück pro cm² ist.

3. Folienmaterial nach Anspruch 1 oder 2, **dadurch gekennzeichnet, daß** metallische Spitzen (8) der Stifte (5) oder Durchkontakte (6) aus dem Folienmaterial (1) einseitig herausragen.

4. Folienmaterial nach einem der Ansprüche 1 bis 3, **dadurch gekennzeichnet, daß** die Dicke (d) des Folienmaterials (1) zwischen 10 µm und 400 µm, vorzugsweise zwischen 20 µm und 300 µm, ist.

5. Folienmaterial nach einem der Ansprüche 1 bis 4, **dadurch gekennzeichnet, daß** die nadelspitzenförmigen konisch zulaufenden Stifte (5) oder Durchkontakte (6) einen Abrundungsradius an der Spitze (8) zwischen 20 nm und 100 nm aufweisen.

6. Folienmaterial nach einem der Ansprüche 1 bis 5, **dadurch gekennzeichnet, daß** die nadelförmigen konischen Stifte (5) oder Durchkontakte (6) im Fußbereich (9) einen Durchmesser kleiner 10 µm, vorzugsweise zwischen 1 µm und 5 µm aufweisen.

7. Verwendung des Folienmaterials nach einem der Ansprüche 1 bis 6, **dadurch gekennzeichnet, daß** das Folienmaterial (1) als Verbindungsmaterial (10) in Form einer Verbindungsmatte zwischen strukturierten Leiterbahnoberflächen von zwei elektronischen Bauteilen verwendet wird und dort automatisch Koppelpunkte durch dichtverteilte nadelspitzenförmige konisch zulaufende metallische Stifte oder Durchkontakte (12) realisiert, wo Leiterbahnen (13) gegenüberliegende Kontaktanschlußflächen (14) aufweisen und/oder an Stellen, an denen sich freiliegende Leiterbahnflächen (15) der Leiterbahnen (13) der beiden elektronischen Bauteile kreuzen.

8. Verwendung des Folienmaterials nach einem der vorhergehenden Ansprüche als elektrisch selektiv verbindendes Material für ein elektronisches Bauteil aus einer Mehrzahl gestapelter Halbleiterbausteine, wobei das Folienmaterial (1) jeweils zwischen den Bausteinen angeordnet ist.

9. Verwendung des Folienmaterials nach einem der Ansprüche 1 bis 6 als elektrisch verbindende Zwischenlage (17) zwischen einem Halbleiterchip (18) und einem Systemträger (19), wobei der Systemträger (19) Leiterbahnen (13) mit Kontaktanschlußflächen (14) aufweist und der Chip (18) Kontaktflächen (20) aufweist, und das Folienmaterial (1) über seine isoliert eingelagerten Stifte (5) elektrische Verbindungen zwischen den Kontaktflächen (10) des Chips (19) und den gegenüberliegenden Kontaktanschlußflächen (14) des Systemträgers (19) bereitstellt.

10. Verwendung des Folienmaterials nach Anspruch 9, **dadurch gekennzeichnet, daß** das Folienmaterial (1) zur Kontaktherstellung mindestens die gesamte Oberfläche (21) des Halbleiterchips (18) auf dessen aktiver Seite mit Kontaktflächen (20) abdeckt, wobei die Leiterbahnen (13) des Systemträgers (19) und/oder die Kontaktanschlußflächen (14) des Systemträgers (19) gegenüberliegend zu den Kontaktflächen (20) des Halbleiterchips (18) angeordnet sind.

11. Folienmaterial nach einem der Ansprüche 1 bis 5, **dadurch gekennzeichnet, daß** das Folienmaterial (1) auf seiner nadelfußseitigen Oberfläche (2) eine mit den Fußenden (22) der konisch zulaufenden Stifte (5) oder der Durchkontakte (6) verbundene Metallbeschichtung aufweist.

12. Folienmaterial nach einem der Ansprüche 1 bis 5 und 11, **dadurch gekennzeichnet, daß** das Kunststoffmaterial (7) im Bereich der Spitzen (8) der konisch zulaufenden Stifte (5) oder Durchkontakte (6) herausgelöst und eine Kavität (24) um die Spitzen (8) herum angeordnet ist, wobei die Kavität (24) um die Spitzen (8) der Stifte (5) oder Durchkontakte (6) durch ein Lot (26) aufgefüllt ist.

13. Folienmaterial nach einem der Ansprüche 11 und 12, **dadurch gekennzeichnet, daß** die Metallbeschichtung 23 auf der nadelfußseitigen Oberfläche (2) Leitungsmuster (27) aufweist.

14. Folienmaterial nach einem der Ansprüche 11 bis 13, **dadurch gekennzeichnet, daß** die Metallbeschichtung (23) das Leitungsmuster (27) eines Systemträgers (19) mit Kontaktanschlußflächen (14) zur Kontaktierung von Kontaktflächen (20) eines Halbleiterchips (18) aufweist.

15. Verwendung des Folienmaterials nach Anspruch 13 oder Anspruch 14 mit strukturierter Metallbeschichtung (28) und mit in einer Kunststoffschicht (7) eingebetteten nadelförmigen konisch zulaufenden Stiften (5) oder Durchkontakten (6) als Systemträger (19) für ein elektronisches Bauteil (16) mit auf dem Systemträger (19) angeordneten Halbleiterchip (18).

16. Verwendung des Folienmaterials nach Anspruch 13 oder 14 mit strukturierter Metallbeschichtung (28) und mit in einer Kunststoffschicht (7) eingebetteten nadelförmigen konisch zulaufenden Stiften (5) oder Durchkontakten (6), deren Spitzen (8) mit Lotmaterial (26) überhöht sind, zur Herstellung elektronischer Bauteile (16) mit einem auf dem Folienmaterial (1) als Systemträger (19) angeordneten Halbleiterchip (18), der mit seinen Kontaktflächen (20) mit dem Lotmaterial (26) verbunden ist.

## Claims

1. Sheet material having metal points (8) and surfaces (2 and 3) located opposite one another, wherein the sheet material has, at a prespecified angle with respect to the surfaces (2 and 3), through-holes (4) from one surface (2) to the surface (3) located opposite, which taper conically and have through-holes (4), pins (5) or through-contacts (6), wherein the pins or through-contacts are needle-point-shaped conical and have electrically conducting material, whereas the sheet material (1) consists of insulating plastics material, **characterised in that** the points have ball like molded solder material extending said points.

2. Sheet material according to claim 1, **characterised in that** the area density of the conically tapering pins (5) or through-contacts (6) is from 1 x 10⁵ units per cm² to 1 x 10⁷ units per cm², preferably from 5 x 10⁵ units per cm² to 1 x 10⁶ units per cm².

3. Sheet material according to claim 1 or 2, **characterised in that** metallic points (8) of the pins (5) or through-contacts (6) project out from the sheet material (1) on one side.

4. Sheet material according to any one of claims 1 to 3, **characterised in that** the thickness (d) of the sheet material (1) is from 10 µm to 400 µm, preferably from 20 µm to 300 µm.

5. Sheet material according to any one of claims 1 to 4, **characterised in that** the needle-point-shaped, conically tapering pins (5) or through-contacts (6) have a rounding-off radius at the point (8) of from 20 nm to 100 nm.

6. Sheet material according to any one of claims 1 to 5, **characterised in that** the needle-shaped, conical pins (5) or through-contacts (6) have, in their base region (9), a diameter of less than 10 µm, preferably of from 1 µm to 5 µm.

7. Use of the sheet material according to any one of claims 1 to 6, **characterised in that** the sheet material (1) is used as connecting material (10) in the form of a connecting mat between structured conductor track surfaces of two electronic components and automatically provides coupling points by means of densely distributed, needle-point-shaped, conically tapering metallic pins or through-contacts (12) wherever conductor tracks (13) have oppositely located contact connection areas (14) and/or at locations where exposed conductor track areas (15) of the conductor tracks (13) of the two electronic components cross one another.

8. Use of the sheet material according to any one of the preceding claims as selectively electrically connecting material for an electronic component consisting of a plurality of stacked semiconductor devices, the sheet material (1) being arranged between the respective modules.

9. Use of the sheet material according to any one of claims 1 to 6 as an electrically connecting intermediate layer (17) between a semiconductor chip (18) and a system carrier (19), the system carrier (19) having conductor tracks (13) with contact connection areas (14) and the chip (18) having contact areas (20), and the sheet material (1) establishing, by means of its pins (5) incorporated in an insulated arrangement, electrical connections between the contact areas (10) of the chip (19) and the contact connection areas (14) of the system carrier (19) which are located opposite.

10. Use of the sheet material according to claim 9, **characterised in that**, for the establishment of contact, the sheet material (1) covers at least the entire surface (21) of the semiconductor chip (18) on its active side provided with contact areas (20), the conductor tracks (13) of the system carrier (19) and/or the contact connection areas (14) of the system carrier (19) being arranged opposite the contact areas (20) of the semiconductor chip (18).

11. Sheet material according to any one of claims 1 to 5, **characterised in that** the sheet material (1) has, on its surface (2) on the needle-base side, a metal coating connected to the base ends (22) of the conically tapering pins (5) or through-contacts (6).

12. Sheet material according to one of claims 1 to 5 and 11, **characterised in that** the plastics material (7) is dissolved away in the region of the points (8) of the conically tapering pins (5) or through-contacts (6) and a cavity (24) is arranged around the points (8), wherein the cavity (24) around the points (8) of the pins (5) or through-contacts (6) is filled with solder (26).

13. Sheet material according to any one of claims 11 and 12, **characterised in that** the metal coating 23 on the surface (2) on the needle-base side has a conduction pattern (27).

14. Sheet material according to any one of claims 11 to 13, **characterised in that** the metal coating (23) has the conduction pattern (27) of a system carrier (19) having contact connection areas (14) for making contact with contact areas (20) of a semiconductor chip (18).

15. Use of the sheet material according to claim 13 or claim 14 having a structured metal coating (28) and having needle-shaped, conically tapering pins (5) or through-contacts (6) embedded in a plastics layer (7), as a system carrier (19) for an electronic component (16) having a semiconductor chip (18) arranged on the system carrier (19).

16. Use of the sheet material according to claim 13 or 14 having a structured metal coating (28) and having needle-shaped, conically tapering pins (5) or through-contacts (6) embedded in a plastics layer (7), the points (8) of which are extended by means of solder material (26), for the production of electronic components (16) having a semiconductor chip (18) which is arranged on the sheet material (1) forming the system carrier (19) and connected to the solder material (26) by means of its contact areas (20).

## Revendications

1. Matériau en feuilles comprenant des pointes métalliques (8) et des surfaces opposées (2 et 3), le matériau en feuille présentant des passages (4) partant de l'une des surfaces (2) vers la surface opposée (3) sous un angle donné par rapport aux surfaces (2 et 3),
avec un rétrécissement conique et les passages (4) présentant des broches (5) ou des contacts traversants (6),
les broches ou contacts traversants étant conçus sous la forme de pointes d'aiguilles coniques et présentant un matériau conducteur électrique, tandis que le matériau en feuilles (1) est constitué d'une matière synthétique isolante, **caractérisé en ce que** les pointes présentent un métal d'apport en forme de sphère dépassant des pointes.

2. Matériau en feuille selon la revendication 1 **caractérisé en ce que** la densité superficielle des broches (5) à rétrécissement conique ou des contacts traversants (6) est entre ¹ x 10⁵ pièces par cm² et 1 x 10⁷ pièces par cm², de préférence entre 5 x10⁵ pièces par cm² et 1 x 10⁶ pièces par cm².

3. Matériau en feuilles selon les revendications 1 ou 2 **caractérisé en ce que** les pointes métalliques (8) des broches (5) ou des contacts traversants (6) dépassent d'un côté du matériau en feuilles (1).

4. Matériau en feuilles selon l'une des revendications de 1 à 3 **caractérisé en ce que** l'épaisseur (d) du matériau en feuilles (1) est entre 10 µm et 400 µm, de préférence entre 20 µm et 300 µm.

5. Matériau en feuilles selon l'une des revendications de 1 à 4 **caractérisé en ce que** les broches (5) à rétrécissement conique en forme de pointes d'aiguilles ou les contacts traversants (6) présentent un rayon de courbure à la pointe (8) entre 20 nm et 100 nm.

6. Matériau en feuilles selon l'une des revendications de 1 à 5 **caractérisé en ce que** les broches (5) coniques en forme d'aiguilles ou les contacts traversants (6) présentent un diamètre à la base (9) inférieur à 10 µm, de préférence entre 1 µm et 5 µm.

7. Utilisation du matériau en feuilles selon l'une des revendications de 1 à 6 **caractérisée en ce que** le matériau en feuilles (1) est employé en tant que matériau de liaison (10) sous la forme d'un tapis de liaison entre des surfaces de pistes conductrices structurées de deux composants électroniques et y réalise automatiquement des points de couplage par l'intermédiaire des broches métalliques à , rétrécissement conique en forme d'aiguilles ou des contacts traversants (12), disposés de façon très dense, où des pistes conductrices (13) présentent des surfaces de contact de raccordement (14) opposées, et/ou des endroits où des surfaces de piste conductrice (15) libres des pistes conductrices (13) des deux composants électroniques se croisent.

8. Utilisation du matériau en feuilles selon l'une des revendications précédentes en tant que matériau de liaison électrique sélectif pour un composant électronique constitué d'une multitude de composants semi-conducteurs empilés, le matériau en feuilles (1) étant disposé respectivement entre les composants.

9. Utilisation du matériau en feuilles selon l'une des revendications de 1 à 6 en tant que couche intermédiaire (17) de liaison électrique entre une puce semi-conductrice (18) et une grille de connexion (19), la grille de connexion (19) présentant des pistes conductrices (13) comprenant des surfaces de raccordement de contact (14) et la puce (18) présentant des surfaces de contact (20), et le matériau en feuilles (1) dispose de liaisons électriques entre les surfaces de contact (10) de la puce (19) et les surfaces de contact de raccordement (14) opposées de la grille de connexion (19) par l'intermédiaire de ses broches (5) isolées qui y sont logées.

10. Utilisation du matériau en feuilles selon la revendication 9 **caractérisée en ce que** le matériau en feuilles (1) recouvre au moins la surface (21) totale de la puce semi-conductrice (18) sur sa face active avec des surfaces de contact (20) pour la réalisation du contact, les pistes conductrices (13) de la grille de connexion (19) et/ou les surfaces de contact de raccordement (14) de la grille de connexion (19) disposées en face des surfaces de contact (20) de la puce semi-conductrice (18).

11. Matériau en feuilles selon l'une des revendications de 1 à 5 **caractérisé en ce que** le matériau en feuilles (1) présente un revêtement métallique relié avec les extrémités de la base (22) des broches (5) à rétrécissement conique ou des contacts traversants (6), sur sa surface (2) située à la base des aiguilles.

12. Matériau en feuilles selon l'une des revendications de 1 à 5 et 11 **caractérisé en ce que** le matériau en matière synthétique (7) dans la zone des pointes (8) des broches (5) à rétrécissement conique ou des contacts traversants (6) est extrait et qu'une cavité (24) est disposée autour des pointes (8), la cavité (24) autour des pointes (8) des broches (5) ou des contacts traversants (6) étant remplie par un métal d'apport (26).

13. Matériau en feuilles selon l'une des revendications 11 et 12 **caractérisé en ce que** le revêtement métallique 23 présente un motif conducteur (27) sur la surface (2) du côté de la base des aiguilles.

14. Matériau en feuilles selon l'une des revendications de 11 à 13 **caractérisé en ce que** le revêtement métallique (23) présente le motif conducteur (27) d'une grille de connexion (19) comprenant des surfaces de contact de raccordement (14) pour le contact avec des surfaces de contact (20) d'une puce semi-conductrice (18).

15. Utilisation du matériau en feuilles selon la revendication 13 ou la revendication 14 comprenant un revêtement métallique (28) structuré et comprenant comme grille de connexion (19) des broches (5) à rétrécissement conique en formes d'aiguilles noyées, ou des contacts traversants (6), dans une couche de matière synthétique (7) pour un composant électronique (16) comprenant une puce semi-conductrice (18) disposée sur la grille de connexion (19).

16. Utilisation du matériau en feuilles selon les revendications 13 ou 14 comprenant un revêtement métallique (28) structuré et comprenant des broches (5) à rétrécissement conique en forme d'aiguilles noyées, ou des contacts traversants (6), dans une couche de matière synthétique (7) dont les pointes (8) sont surélevées par du métal d'apport (26), pour la fabrication de composants électroniques (16) comprenant une puce semi-conductrice (18) disposée sur le matériau en feuilles (1) formant la grille de connexion (19), puce semi-conductrice en contact avec le métal d'apport (26) par l'intermédiaire de ses surfaces de contact (20).
